# EUROPÄISCHE PATENTSCHRIFT

(11) **EP 3 753 107 B1**
(45) Veröffentlichungstag und Bekanntmachung des Hinweises auf die Patenterteilung: **08.11.2023**
(21) Anmeldenummer: 18716972.7
(22) Anmeldetag: 03.04.2018
(51) Int. Cl.: H03K 17/10

(54) **SCHALTUNGSANORDNUNG UND STROMRICHTERMODUL MIT IN REIHE GESCHALTETEN HALBLEITERSCHALTERN**
CIRCUIT ARRANGEMENT AND POWER CONVERTER MODULE HAVING SEMICONDUCTOR SWITCHES CONNECTED IN SERIES
ENSEMBLE CIRCUIT ET MODULE REDRESSEUR AYANT DES INTERRUPTEURS À SEMI-CONDUCTEURS MONTÉS EN SÉRIE

(43) Veröffentlichungstag der Anmeldung: 23.12.2020
(73) Patentinhaber: Siemens Energy Global GmbH & Co. KG, 81739 München (DE)
(72) Erfinder: DÖRING, David, 91074 Herzogenaurach (DE); GIERING, Gerald Franz, 90562 Kalchreuth (DE); WÜRFLINGER, Klaus, 90419 Nürnberg (DE)
(86) Internationale Anmeldenummer: PCT/EP2018/058457
(87) Internationale Veröffentlichungsnummer: WO 2019/192675

(56) Entgegenhaltungen:
- WO-A1-02/23704
- DE-U1-202012 012 080
- US-A1- 2011 148 368

## Beschreibung

Die Erfindung betrifft eine Schaltungsanordnung, die in Reihe geschaltete Halbleiterschalter aufweist, und ein Stromrichtermodul mit einer derartigen Schaltungsanordnung.

Halbleiterschalter wie ein Bipolartransistor mit isoliertem Gate (IGBT = Insulated-Gate Bipolar Transistor) werden durch einen Treiber angesteuert, der mit elektrischer Energie versorgt werden muss. Insbesondere Stromrichtermodule weisen häufig eine Reihenschaltung von Halbleiterschaltern auf. Die Erfindung betrifft insbesondere die Energieversorgung der Treiber der Halbleiterschalter einer derartigen Reihenschaltung. Ein Treiber eines einzelnen Halbleiterschalters wird beispielsweise häufig aus einem mit dem Halbleiterschalter verbundenen Kondensator mit Energie versorgt. Diese Art der Energieversorgung eines Treibers eines Halbleiterschalters ist jedoch bei einer Reihenschaltung von Halbleiterschaltern mit Schwierigkeiten verbunden, weil eine Energieauskopplung entweder aus einer Kondensatorschaltung für die gesamte Reihenschaltung der Halbleiterschalter und damit aus einer in der Regel sehr hohen Spannung oder aus nur einem Kondensator mehrerer in Reihe geschalteter Kondensatoren, deren Spannungen Schwankungen der Spannungsaufteilung zwischen den Kondensatoren unterliegt, erfolgt.

Aus der internationalen Patentanmeldung WO 02/23704 A1 ist eine Schaltungsanordnung mit vier in Reihe geschalteten Halbleiterschaltern bekannt. Dabei ist jeder Halbleiterschalter mit einer Ansteuerschaltung versehen. Der jeweils über einem der Halbleiterschalter auftretende Spannungsabfall liefert dabei die Energie für die Energieversorgung der Ansteuerschaltung dieses Halbleiterschalters.

Der Erfindung liegt die Aufgabe zugrunde, eine Schaltungsanordnung und ein Stromrichtermodul anzugeben, die in Reihe geschaltete Halbleiterschalter aufweisen und insbesondere hinsichtlich der Energieversorgung der Treiber der Halbleiterschalter verbessert sind.

Die Aufgabe wird erfindungsgemäß durch eine Schaltungsanordnung mit den Merkmalen des Anspruchs 1 und ein Stromrichtermodul mit den Merkmalen des Anspruchs 9 gelöst.

Vorteilhafte Ausgestaltungen der Erfindung sind Gegenstand der Unteransprüche.

Eine erfindungsgemäße Schaltungsanordnung umfasst eine gerade Anzahl in Reihe geschalteter Halbleiterschalter, die jeweils zwei Lastanschlüsse und einen Steueranschluss aufweisen und paarweise einander zugeordnet sind, für jeden Halbleiterschalter einen Treiber zur Ansteuerung des Halbleiterschalters über dessen Steueranschluss und für je zwei ein Schalterpaar bildende Halbleiterschalter ein Schaltnetzteil, das aus einer elektrischen Spannung zwischen den beiden Lastanschlüssen eines ersten Halbleiterschalters des Schalterpaares mit Energie versorgt wird und sowohl den Treiber des ersten Halbleiterschalters als auch den Treiber des zweiten Halbleiterschalters des Schalterpaares mit Energie versorgt.

Die Erfindung sieht also vor, die Treiber in Reihe geschalteter Halbleiterschalter paarweise durch jeweils ein Schaltnetzteil mit Energie zu versorgen. Das Schaltnetzteil wird durch eine Spannung zwischen den Lastanschlüssen eines ersten Halbleiterschalters mit Energie versorgt. Dabei wird eine Spannung, die an dem ersten Halbleiterschalter in dessen abgeschaltetem Zustand eines jeden Schaltpaares anliegt, genutzt, um das Schaltnetzteil des jeweiligen Schalterpaares mit Energie zu versorgen, so dass die oben genannten Probleme einer Energieversorgung aus einer Kondensatorschaltung nicht auftreten.

Eine Ausgestaltung der Erfindung sieht vor, dass zu jedem Halbleiterschalter eine Freilaufdiode parallel geschaltet ist. Dadurch werden die Halbleiterschalter vor Überspannungen bei Änderungen ihres Schaltzustands geschützt.

Bei einer weiteren Ausgestaltung der Erfindung ist jeder Halbleiterschalter ein Bipolartransistor mit isoliertem Gate, dessen Lastanschlüsse sein Emitter und sein Kollektor sind und dessen Steueranschluss sein Gate ist. Insbesondere sind je zwei in der Reihenschaltung aufeinander folgende Halbleiterschalter dabei durch eine elektrische Verbindung des Emitters eines der beiden Halbleiterschalter und des Kollektors des anderen der beiden Halbleiterschalter elektrisch miteinander verbunden. Bipolartransistoren mit isoliertem Gate vereinigen Vorteile von Bipolartransistoren und Feldeffekttransistoren und sind daher besonders geeignete Halbleiterschalter, insbesondere für Schaltungsanordnungen für Stromrichtermodule.

Eine weitere Ausgestaltung der Erfindung sieht vor, dass die Halbleiterschalter in der Reihenfolge ihrer Reihenschaltung (übereinander oder nebeneinander) gestapelt angeordnet sind. Dies bewirkt eine platzsparende Ausführung der Schaltungsanordnung und ermöglicht eine einfache Verschaltung der Halbleiterschalter.

Die erfindungsgemäße Schaltungsanordnung mit wenigstens vier Halbleiterschaltern sieht vor, dass die ersten Halbleiterschalter der Schalterpaare eine Teilreihenschaltung bilden, die in der Reihenschaltung der Halbleiterschalter zwischen einer ersten Teilmenge zweiter Halbleiterschalter der Schalterpaare und einer zweiten Teilmenge zweiter Halbleiterschalter der Schalterpaare angeordnet ist. Die Mächtigkeiten der beiden Teilmengen zweiter Halbleiterschalter sind dabei vorzugsweise im Falle einer geraden Anzahl von Schalterpaaren gleich groß und unterscheiden sich im Falle einer ungeraden Anzahl von Schalterpaaren um Eins voneinander. Ferner ist zwischen den beiden Halbleiterschaltern jedes Schalterpaares in der Reihenschaltung der Halbleiterschalter vorzugsweise eine Anzahl von Halbleiterschaltern angeordnet, die um Eins kleiner als die Mächtigkeit derjenigen Teilmenge zweiter Halbleiterschalter ist, der der zweite Halbleiterschalter des Schalterpaares angehört. Diese Ausgestaltungen der Erfindung berücksichtigen, dass einander entsprechende Lastanschlüsse der beiden Halbleiterschalter eines Schalterpaares aufgrund der Reihenschaltung der Halbleiterschalter auf voneinander verschiedenen elektrischen Potentialen liegen. Diese Potentialdifferenz muss von dem Schaltnetzteil, das die Treiber der beiden Halbleiterschalter mit Energie versorgt, ausgeglichen werden. Es ist daher vorteilhaft, die Potentialdifferenz zwischen den beiden Halbleiterschaltern jedes Schalterpaares möglichst klein zu halten. Dies wird durch die vorgenannte Anordnung der Halbleiterschalter erreicht, die eine möglichst geringe Anzahl von zwischen die beiden Halbleiterschalter jedes Schalterpaares geschalteten Halbleiterschaltern anderer Schalterpaare realisiert, wobei die ersten Halbleiterschalter eine Teilreihenschaltung bilden.

Ein erfindungsgemäßes Stromrichtermodul umfasst eine Schaltungsanordnung gemäß einer der vorgenannten Ausgestaltungen, eine mit den beiden Enden der Reihenschaltung der Halbleiterschalter verbundene Kondensatorschaltung mit wenigstens einem Kondensator und zwei Modulanschlüsse, die Endanschlüsse der von den ersten Halbleiterschaltern der Schalterpaare gebildeten Teilreihenschaltung sind. Dabei kann die Kondensatorschaltung eine Reihenschaltung mehrerer Kondensatoren sein. Insbesondere kann die Kondensatorschaltung eine Anzahl von Kondensatoren aufweisen, die mit der Anzahl der Schalterpaare von Halbleiterschaltern übereinstimmt. Die Vorteile eines erfindungsgemäßen Stromrichtermoduls ergeben sich aus den oben genannten Vorteilen der Schaltungsanordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Stromrichtermodul mit vier in Reihe geschalteten Halbleiterschaltern,
FIG 2 ein Stromrichtermodul mit acht in Reihe geschalteten Halbleiterschaltern.

Einander entsprechende Teile sind in den Figuren mit denselben Bezugszeichen versehen.

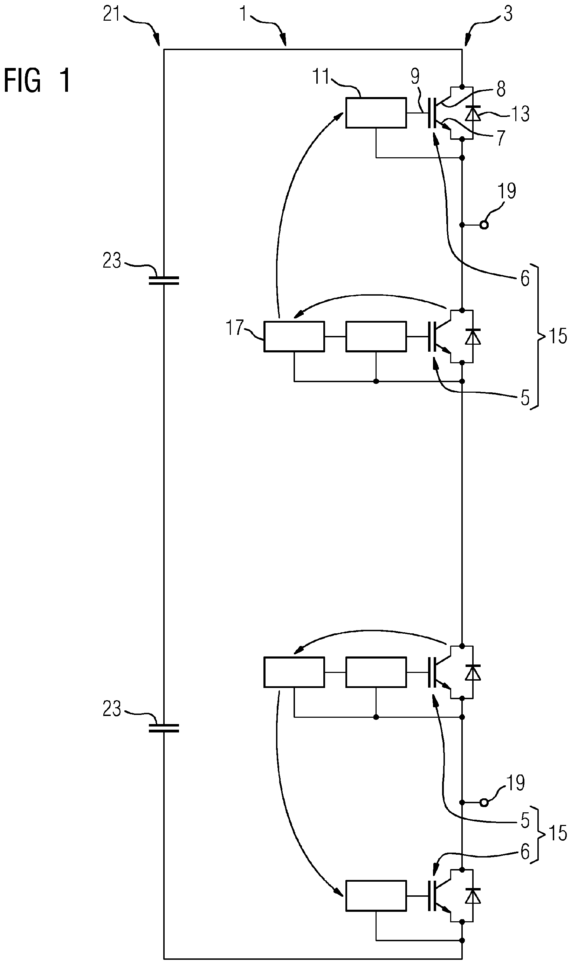

Figur 1 zeigt einen Schaltplan eines erfindungsgemäßen Stromrichtermoduls 1 mit einer erfindungsgemäßen Schaltungsanordnung 3, die vier in Reihe geschaltete Halbleiterschalter 5, 6 aufweist.

Jeder Halbleiterschalter 5, 6 ist als ein IGBT ausgebildet und weist zwei Lastanschlüsse 7, 8 (den Emitter 7 und den Kollektor 8) und einen Steueranschluss 9 (das Gate) auf. Je zwei in der Reihenschaltung aufeinander folgende Halbleiterschalter 5, 6 sind durch eine elektrische Verbindung des Emitters 7 eines der beiden Halbleiterschalter 5, 6 und des Kollektors 8 des anderen der beiden Halbleiterschalter 5, 6 elektrisch miteinander verbunden.

Die Schaltungsanordnung 3 weist ferner für jeden Halbleiterschalter 5, 6 einen Treiber 11 und eine Freilaufdiode 13 auf. Mit dem Treiber 11 wird der Halbleiterschalter 5, 6 über den Steueranschluss 9 angesteuert. Die Freilaufdiode 13 ist parallel zu dem Halbleiterschalter 5, 6 geschaltet, wobei die Anode der Freilaufdiode 13 mit dem Emitter 7 des Halbleiterschalters 5, 6 verbunden ist und die Kathode der Freilaufdiode 13 mit dem Kollektor 8 des Halbleiterschalters 5, 6 verbunden ist.

Die Halbleiterschalter 5, 6 sind einander paarweise zugeordnet und bilden somit zwei Schalterpaare 15. Die Schaltungsanordnung 3 weist für jedes Schalterpaar 15 ein Schaltnetzteil 17 auf, das aus einer elektrischen Spannung zwischen den beiden Lastanschlüssen 7, 8 eines ersten Halbleiterschalters 5 des Schalterpaares 15 mit Energie versorgt wird und sowohl den Treiber 11 des ersten Halbleiterschalters 5 als auch den Treiber 11 des zweiten Halbleiterschalters 6 des Schalterpaares 15 mit Energie versorgt. Die Energieversorgung eines Schaltnetzteils 17 und eines zweiten Halbleiterschalters 6 durch ein Schaltnetzteil 17 sind jeweils durch einen Pfeil angedeutet.

Die beiden ersten Halbleiterschalter 5 der Schalterpaare 15 bilden eine Teilreihenschaltung, die in der Reihenschaltung der Halbleiterschalter 5, 6 zwischen den beiden zweiten Halbleiterschaltern 6 der Schalterpaare 15 angeordnet ist, wobei die beiden Halbleiterschalter 5, 6 jedes Schalterpaares 15 aufeinander folgend angeordnet sind.

Das Stromrichtermodul 1 weist ferner zwei Modulanschlüsse 19 und eine Kondensatorschaltung 21 auf. Die Modulanschlüsse 19 sind die Endanschlüsse der von den ersten Halbleiterschaltern 5 der Schalterpaare 15 gebildeten Teilreihenschaltung. Die Kondensatorschaltung 21 ist mit den beiden Enden der Reihenschaltung der Halbleiterschalter 5, 6 verbunden und weist zwei in Reihe geschaltete Kondensatoren 23 auf.

Die Halbleiterschalter 5, 6 sind in der Reihenfolge ihrer Reihenschaltung übereinander oder nebeneinander gestapelt angeordnet.

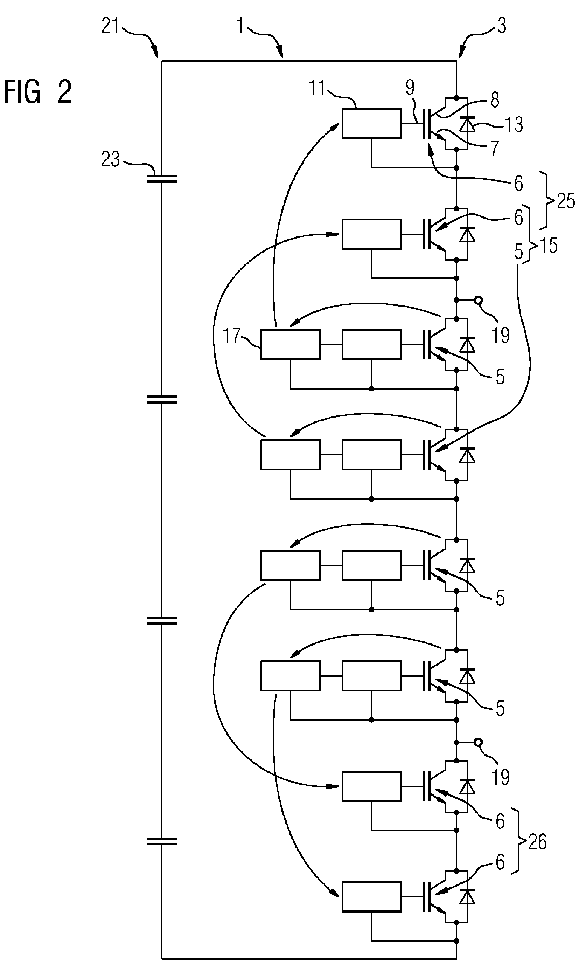

Figur 2 zeigt einen Schaltplan eines erfindungsgemäßen Stromrichtermoduls 1 mit einer erfindungsgemäßen Schaltungsanordnung 3, die acht in Reihe geschaltete Halbleiterschalter 5, 6 aufweist.

Jeder Halbleiterschalter 5, 6 ist als ein IGBT ausgebildet und weist zwei Lastanschlüsse 7, 8 (den Emitter 7 und den Kollektor 8) und einen Steueranschluss 9 (das Gate) auf. Je zwei in der Reihenschaltung aufeinander folgende Halbleiterschalter 5, 6 sind durch eine elektrische Verbindung des Emitters 7 eines der beiden Halbleiterschalter 5, 6 und des Kollektors 8 des anderen der beiden Halbleiterschalter 5, 6 elektrisch miteinander verbunden.

Die Schaltungsanordnung 3 weist ferner für jeden Halbleiterschalter 5, 6 einen Treiber 11 und eine Freilaufdiode 13 auf. Mit dem Treiber 11 wird der Halbleiterschalter 5, 6 über den Steueranschluss 9 angesteuert. Die Freilaufdiode 13 ist parallel zu dem Halbleiterschalter 5, 6 geschaltet, wobei die Anode der Freilaufdiode 13 mit dem Emitter 7 des Halbleiterschalters 5, 6 verbunden ist und die Kathode der Freilaufdiode 13 mit dem Kollektor 8 des Halbleiterschalters 5, 6 verbunden ist.

Die Halbleiterschalter 5, 6 sind einander paarweise zugeordnet und bilden somit vier Schalterpaare 15. Die Schaltungsanordnung 3 weist für jedes Schalterpaar 15 ein Schaltnetzteil 17 auf, das aus einer elektrischen Spannung zwischen den beiden Lastanschlüssen 7, 8 eines ersten Halbleiterschalters 5 des Schalterpaares 15 mit Energie versorgt wird und sowohl den Treiber 11 des ersten Halbleiterschalters 5 als auch den Treiber 11 des zweiten Halbleiterschalters 6 des Schalterpaares 15 mit Energie versorgt. Die Energieversorgung eines Schaltnetzteils 17 und eines zweiten Halbleiterschalters 6 durch ein Schaltnetzteil 17 sind jeweils durch einen Pfeil angedeutet.

Die vier ersten Halbleiterschalter 5 der Schalterpaare 15 bilden eine Teilreihenschaltung, die in der Reihenschaltung der Halbleiterschalter 5, 6 zwischen einer ersten Teilmenge 25 zweiter Halbleiterschalter 6 der Schalterpaare 15 und einer zweiten Teilmenge 26 zweiter Halbleiterschalter 6 der Schalterpaare 15 angeordnet ist, wobei jede Teilmenge 25, 26 zwei zweite Halbleiterschalter 6 aufweist und zwischen den beiden Halbleiterschaltern 5, 6 jedes Schalterpaares 15 genau ein Halbleiterschalter 5, 6 eines anderen Schalterpaares 15 angeordnet ist.

Das Stromrichtermodul 1 weist ferner zwei Modulanschlüsse 19 und eine Kondensatorschaltung 21 auf. Die Modulanschlüsse 19 sind die Endanschlüsse der von den ersten

Halbleiterschaltern 5 der Schalterpaare 15 gebildeten Teilreihenschaltung. Die Kondensatorschaltung 21 ist mit den beiden Enden der Reihenschaltung der Halbleiterschalter 5, 6 verbunden und weist vier in Reihe geschaltete Kondensatoren 23 auf.

Die Halbleiterschalter 5, 6 sind in der Reihenfolge ihrer Reihenschaltung übereinander oder nebeneinander gestapelt angeordnet.

Bei beiden in den Figuren 1 und 2 gezeigten Stromrichtermodulen 1 ist jedes Schaltnetzteil 17 dazu ausgebildet, die zwischen den beiden Lastanschlüssen 7, 8 des jeweiligen ersten Halbleiterschalters 5 anliegende Spannung zu messen und Energie aus dieser Spannung auszukoppeln, wenn der erste Halbleiterschalter 5 abgeschaltet (sperrend) ist. Ferner gleicht das Schaltnetzteil 17 eine Potentialdifferenz zwischen den einander entsprechenden Lastanschlüssen 7, 8 (beispielsweise zwischen den Emittern 7) der beiden Halbleiterschalter 5, 6 des jeweiligen Schalterpaares 15 aus. Die einander benachbarte Anordnung der beiden Halbleiterschalter 5, 6 eines Schalterpaares 15 im Falle der in Figur 1 gezeigten Schaltungsanordnung 3 und die Anordnung der beiden Halbleiterschalter 5, 6 eines Schalterpaares 15 mit nur jeweils einem zwischen den beiden Halbleiterschaltern 5, 6 angeordneten Halbleiterschalter 5, 6 eines anderen Schalterpaares 15 im Falle der in Figur 2 gezeigten Schaltungsanordnung 3 bewirken jeweils vorteilhaft eine relativ geringe Potentialdifferenz zwischen den beiden Halbleiterschaltern 5, 6 eines Schalterpaares 15.

Bei beiden in den Figuren 1 und 2 gezeigten Stromrichtermodulen 1 kann ferner vorgesehen sein, zusätzlich zu der Energieversorgung der Schaltnetzteile 17 aus an den ersten Halbleiterschaltern 5 anliegenden Spannungen eine redundante Energieversorgung der Schaltnetzteile 17, beispielsweise aus einem Strom oder der Kondensatorschaltung 21 zu ermöglichen, die bedarfsweise genutzt werden kann.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch den folgenden Anspruch 1 festgelegt ist.

### Bezugszeichenliste

- 1: Stromrichtermodul
- 3: Schaltungsanordnung
- 5, 6: Halbleiterschalter
- 7, 8: Lastanschluss
- 9: Steueranschluss
- 11: Treiber
- 13: Freilaufdiode
- 15: Schalterpaar
- 17: Schaltnetzteil
- 19: Modulanschluss
- 21: Kondensatorschaltung
- 23: Kondensator
- 25, 26: Teilmenge

## Patentansprüche

1. Schaltungsanordnung (3), umfassend
- eine gerade Anzahl in Reihe geschalteter Halbleiterschalter (5, 6), die jeweils zwei Lastanschlüsse (7, 8) und einen Steueranschluss (9) aufweisen und paarweise einander zugeordnet sind,
- für jeden Halbleiterschalter (5, 6) einen Treiber (11) zur Ansteuerung des Halbleiterschalters (5, 6) über dessen Steueranschluss (9) und
- für je zwei ein Schalterpaar (15) bildende Halbleiterschalter (5, 6) ein Schaltnetzteil (17), das aus einer elektrischen Spannung zwischen den beiden Lastanschlüssen (7, 8) eines ersten Halbleiterschalters (5) des Schalterpaares (15) mit Energie versorgt wird und sowohl den Treiber (11) des ersten Halbleiterschalters (5) als auch den Treiber (11) des zweiten Halbleiterschalters (6) des Schalterpaares (15) mit Energie versorgt,
wobei die Schaltungsanordnung (3) wenigstens vier Halbleiterschalter (5, 6) aufweist, wobei die ersten Halbleiterschalter (5) der Schalterpaare (15) eine Teilreihenschaltung bilden, die in der Reihenschaltung der Halbleiterschalter (5, 6) zwischen einer ersten Teilmenge (25) zweiter Halbleiterschalter (6) der Schalterpaare (15) und einer zweiten Teilmenge (26) zweiter Halbleiterschalter (6) der Schalterpaare (15) angeordnet ist.

2. Schaltungsanordnung (3) nach Anspruch 1, wobei zu jedem Halbleiterschalter (5, 6) eine Freilaufdiode (13) parallel geschaltet ist.

3. Schaltungsanordnung (3) nach Anspruch 1 oder 2, wobei jeder Halbleiterschalter (5, 6) ein Bipolartransistor mit isoliertem Gate ist, dessen Lastanschlüsse (7, 8) sein Emitter und sein Kollektor sind und dessen Steueranschluss (9) sein Gate ist.

4. Schaltungsanordnung (3) nach Anspruch 3, wobei je zwei in der Reihenschaltung aufeinander folgende
Halbleiterschalter (5, 6) durch eine elektrische Verbindung des Emitters eines der beiden Halbleiterschalter (5, 6) und des Kollektors des anderen der beiden Halbleiterschalter (5, 6) elektrisch miteinander verbunden sind.

5. Schaltungsanordnung (3) nach einem der vorhergehenden Ansprüche, wobei die Halbleiterschalter (5, 6) in der Reihenfolge ihrer Reihenschaltung gestapelt angeordnet sind.

6. Schaltungsanordnung (3) nach einem der vorhergehenden Ansprüche, wobei die Mächtigkeiten der beiden Teilmengen (25, 26) zweiter Halbleiterschalter (6) im Falle einer geraden Anzahl von Schalterpaaren (15) gleich groß sind und sich im Falle einer ungeraden Anzahl von Schalterpaaren (15) um Eins unterscheiden.

7. Schaltungsanordnung (3) nach einem der vorhergehenden Ansprüche, wobei zwischen den beiden Halbleiterschaltern (5, 6) jedes Schalterpaares (15) in der Reihenschaltung der Halbleiterschalter (5, 6) eine Anzahl von Halbleiterschaltern (5, 6) angeordnet ist, die um Eins kleiner als die Mächtigkeit derjenigen Teilmenge (25, 26) zweiter Halbleiterschalter (6) ist, der der zweite Halbleiterschalter (6) des Schalterpaares (15) angehört.

8. Stromrichtermodul (1), umfassend
- eine Schaltungsanordnung (3) nach einem der Ansprüche 1 bis 7,
- eine mit den beiden Enden der Reihenschaltung der Halbleiterschalter (5, 6) verbundene
Kondensatorschaltung (21) mit wenigstens einem Kondensator (23) und
- zwei Modulanschlüsse (19), die Endanschlüsse der von den ersten Halbleiterschaltern (5) der Schalterpaare (15) gebildeten Teilreihenschaltung sind.

9. Stromrichtermodul (1) nach Anspruch 8, wobei die Kondensatorschaltung (21) eine Reihenschaltung mehrerer Kondensatoren (23) ist.

10. Stromrichtermodul (1) nach Anspruch 9, wobei die Kondensatorschaltung (21) eine Anzahl von Kondensatoren (23) aufweist, die mit der Anzahl der Schalterpaare (15) der Schaltungsanordnung (3) übereinstimmt.

## Claims

1. Circuit arrangement (3), comprising
- an even number of series-connected semiconductor switches (5, 6) that each have two load terminals (7, 8) and a control terminal (9) and are assigned to one another in pairs,
- a driver (11) for each semiconductor switch (5, 6), for driving the semiconductor switch (5, 6) via the control terminal (9) thereof and
- a switched-mode power supply (17) for each two semiconductor switches (5, 6) forming a pair of switches (15), which switched-mode power supply is supplied with energy from a voltage between the two load terminals (7, 8) of a first semiconductor switch (5) of the pair of switches (15) and supplies energy both to the driver (11) of the first semiconductor switch (5) and to the driver (11) of the second semiconductor switch (6) of the pair of switches (15), wherein the circuit arrangement (3) has at least four semiconductor switches (5, 6), wherein the first semiconductor switches (5) of the pairs of switches (15) form a partial series circuit that is arranged between a first subset (25) of second semiconductor switches (6) of the pairs of switches (15) and a second subset (26) of second semiconductor switches (6) of the pairs of switches (15) in the series circuit of the semiconductor switches (5, 6).

2. Circuit arrangement (3) according to Claim 1, wherein a freewheeling diode (13) is connected in parallel with each semiconductor switch (5, 6).

3. Circuit arrangement (3) according to Claim 1 or 2, wherein each semiconductor switch (5, 6) is an insulated-gate bipolar transistor whose load terminals (7, 8) are its emitter and its collector and whose control terminal (9) is its gate.

4. Circuit arrangement (3) according to Claim 3, wherein each two successive semiconductor switches (5, 6) in the series circuit are electrically connected to one another by way of an electrical connection of the emitter of one of the two semiconductor switches (5, 6) and of the collector of the other of the two semiconductor switches (5, 6).

5. Circuit arrangement (3) according to one of the preceding claims, wherein the semiconductor switches (5, 6) are arranged stacked in the order of their series circuit.

6. Circuit arrangement (3) according to one of the preceding claims, wherein the cardinal numbers of the two subsets (25, 26) of second semiconductor switches (6) are the same in the case of an even number of pairs of switches (15) and differ from one another by one in the case of an odd number of pairs of switches (15).

7. Circuit arrangement (3) according to one of the preceding claims, wherein arranged between the two semiconductor switches (5, 6) of each pair of switches (15) in the series circuit of the semiconductor switches (5, 6) is a number of semiconductor switches (5, 6) that is one less than the cardinal number of that subset (25, 26) of second semiconductor switches (6) to which the second semiconductor switch (6) of the pair of switches (15) belongs.

8. Converter module (1), comprising
- a circuit arrangement (3) according to one of Claims 1 to 7,
- a capacitor circuit (21) connected to the two ends of the series circuit of the semiconductor switches (5, 6) and having at least one capacitor (23) and
- two module terminals (19), which are end terminals of the partial series circuit formed by the first semiconductor switches (5) of the pairs of switches (15).

9. Converter module (1) according to Claim 8, wherein the capacitor circuit (21) is a series circuit of a plurality of capacitors (23).

10. Converter module (1) according to Claim 9, wherein the capacitor circuit (21) has a number of capacitors (23) that matches the number of pairs of switches (15) of the circuit arrangement (3).

## Revendications

1. Montage (3), comprenant
- un nombre pair d'interrupteurs (5, 6) à semiconducteur montés en série, qui ont chacun deux bornes (7, 8) de charge et une borne (9) de commande, et qui sont associés l'un à l'autre par paire,
- pour chaque interrupteur (5, 6) à semiconducteur, un circuit (11) d'attaque pour la commande de l'interrupteur (5, 6) à semiconducteur par sa borne (9) de commande et
- pour respectivement deux interrupteurs (5, 6) à semiconducteur formant une paire (15) d'interrupteurs, une partie (17) de réseau de commutation ; qui est alimentée en énergie à partir d'une tension électrique entre les deux bornes (7, 8) de charge d'un premier interrupteur (5) à semiconducteur de la paire (15) d'interrupteurs et qui alimente en énergie tant le circuit (11) d'attaque du premier interrupteur (5) à semiconducteur qu'également le circuit (11) d'attaque du deuxième interrupteur (6) à semiconducteur de la paire (15) d'interrupteurs,
dans lequel le montage (3) a au moins quatre interrupteurs (5, 6) à semiconducteur, dans lequel les premiers interrupteurs (5) à semiconducteur des paires (15) d'interrupteurs forment un circuit série partiel, qui est monté dans le circuit série des interrupteurs (5, 6) à semiconducteur entre un premier ensemble (25) partiel de deuxièmes interrupteurs (6) à semiconducteur des paires (15) d'interrupteurs et un deuxième ensemble (26) partiel de deuxièmes interrupteurs (6) à semiconducteur des paires (15) d'interrupteurs.

2. Montage (3) suivant la revendication 1, dans lequel une diode (13) de roue libre est montée en parallèle avec chaque interrupteur (5, 6) à semiconducteur.

3. Montage (3) suivant la revendication 1 ou 2, dans lequel chaque interrupteur (5, 6) à semiconducteur est un transistor bipolaire à grille isolée, dont les bornes (7, 8) de charge sont son émetteur et son collecteur et dont la borne (9) de commande est sa grille.

4. Montage (3) suivant la revendication 3, dans lequel respectivement deux interrupteurs (5, 6) à semiconducteur se succédant dans le circuit série sont reliés électriquement entre eux par une liaison électrique de l'émetteur des deux interrupteurs (5, 6) à semiconducteur et du collecteur de l'autre des deux interrupteurs (5, 6) à semiconducteur.

5. Montage (3) suivant l'une des revendications précédentes, dans lequel les interrupteurs (5, 6) à semiconducteur sont disposés en étant empilés dans l'ordre de leur circuit série.

6. Montage (3) suivant l'une des revendications précédentes, dans lequel les cardinaux des deux ensembles (25, 26) partiels de deuxièmes interrupteurs (6) à semiconducteur sont, dans le cas d'un nombre pair de paires (15) d'interrupteurs de même grandeur, et sont différents de un, dans le cas d'un nombre impair de paires (15) d'interrupteurs.

7. Montage (3) suivant l'une des revendications précédentes, dans lequel entre les deux interrupteurs (5, 6) à semiconducteur de chaque paire (15) d'interrupteurs est monté, dans le circuit série des interrupteurs (5, 6) à semiconducteur, un nombre d'interrupteurs (5, 6) à semiconducteur, qui est plus petit de un que le cardinal des ensembles (25, 26) partiels de deuxièmes interrupteurs (6) à semiconducteur, qui appartient aux deuxièmes interrupteurs (6) à semiconducteur de la paire (15) d'interrupteurs.

8. Module (1) de convertisseur, comprenant
- un montage (3) suivant l'une des revendications 1 à 7,
- un circuit (21) de condensateur, qui est relié aux deux extrémités du circuit série des interrupteurs (5, 6) à semiconducteur et qui a au moins un condensateur (23), et
- deux bornes (19) de module, qui sont des bornes d'extrémité du circuit série partiel formé par les premiers interrupteurs (5) à semiconducteur des paires (15) d'interrupteurs.

9. Module (1) de convertisseurs suivant la revendication 8, dans lequel le circuit (21) de condensateur est un circuit série de plusieurs condensateurs (23).

10. Module (1) de convertisseurs suivant la revendication 9, dans lequel le circuit (21) de condensateur a un nombre de condensateurs (23), qui coïncide avec le nombre des paires (15) d'interrupteurs du montage (3).
